# EUROPEAN PATENT SPECIFICATION

(11) **EP 1 375 623 B1**
(45) Date of publication and mention of the grant of the patent: **28.10.2009**
(21) Application number: 02708654.5
(22) Date of filing: 25.03.2002
(51) Int. Cl.: C09K 11/06, C08L 83/04, H01L 23/373

(54) **METHOD OF MANUFACTURING A SEALED CONTAINER FILLED WITH AN EXTRUDABLE CROSS-LINKED GREASE-LIKE HEAT RADIATING MATERIAL**
VERFAHREN ZUR HERSTELLUNG EINES MIT EINEM EXTRUDIERBAREN, VERNETZTEN, FETTÄHNLICHEN WÄRMEABSTRAHLENDEN MATERIAL GEFÜLLTEN, VERSIEGELTEN BEHÄLTERS
PROCÉDÉ DE FABRICATION D'UN CONTENANT SCELLÉ ET REMPLI PAR UN MATÉRIAU DE RAYONNEMENT THERMIQUE EXTRUDABLE, RÉTICULÉ ET GRAISSEUX

(30) Priority: 30.03.2001 JP 2001099075
(43) Date of publication of application: 02.01.2004
(73) Proprietor: Geltec Co., Ltd, Tokyo 108-0075 (JP)
(72) Inventor: IMAI, Takashi, Shimizu-shi, Shizuoka 424-0017 (JP); MASUDA, Masahiko, Yaizu-shi, Shizuoka 425-0062 (JP); FURUTANI, Orie, Shizuoka-shi, Shizuoka 422-8046 (JP)
(74) Representative: Moinas, Michel
(86) International application number: PCT/JP2002/002857
(87) International publication number: WO 2002/081592

(56) References cited:
- EP-A- 0 630 952
- EP-A2- 1 167 457
- JP-A- 9 017 922
- JP-A- 11 049 959
- JP-A- 62 281 434
- US-A- 5 021 494
- US-A- 5 100 568
- US-A- 5 518 758
- ANONYMOUS: "Filled Silicone Gel As a Thermal Transfer Medium in Electronic Packages" IBM TECHNICAL DISCLOSURE BULLETIN, IBM CORP. NEW YORK, US, vol. 30, no. 12, 1 May 1988 (1988-05-01), page 146, XP002158633 ISSN: 0018-8689 & US 5 518 758 A (TIBURTIUS ET AL) 21 May 1996 (1996-05-21)

## Description

### BACKGROUND OF THE INVENTION

### FIELD OF THE INVENTION

This invention relates to a process for producing a container, e.g., tube or syringe, filled with and sealing an extrudable, crosslinked, grease-like heat-radiating material.

### DESCRIPTION OF THE PRIOR ART

Recently, electronic devices are becoming more functional, smaller, lighter, and more portable and space-saving. As a result, electronic parts for these devices generate larger quantities of heat while in service, and have smaller spaces into which heat is released. Therefore, efficient removal of heat is one of the important themes for developing electronic devices.

Heat can be efficiently removed by various methods, of which use of a heat sink (heat-absorbing/radiating device) has been extensively applied for its advantages, e.g., simple structure, little noise generated, no power source required and low in cost. A heat sink is made of aluminum or aluminum alloy for its high heat-releasing capacity, high heat conductivity, lightness and low cost, or titanium, titanium alloy, copper, copper alloy, silver, gold or the like for special purposes. These metallic materials, however, are also highly electroconductive to possibly cause failure of electronic parts, e.g., LSI, CPU, power transistor, diode, thyristor, substrate and common power source as a heat-generating source in an electronic device, e.g., personal computer, microprocessor or CD-ROM drive, when they are directly connected to these parts. Therefore, it is necessary to use a heat sink in combination with a sheet, paint, compound or the like which is thermoconductive and electrically insulating.

Moreover, the sheet, paint, compound or the like for mounting a heat sink must be well shape-following to secure efficient heat transfer to the heat sink; minute irregularities between the heat-generating source and heat sink deteriorate thermal conductivity of the assembly, because air layer in the irregularities work as a heat insulating layer.

The materials proposed for these purposes include zinc white, silica, alumina, aluminum nitride, boron nitride, silicon nitride, silicon carbide, carbon and diamond as thermoconductive materials; and epoxy, polyimide, polycarbonate, polyamide, polyphenylene oxide, urethane, phenol, polyester, fluorine, polyethylene, polypropylene and polyvinyl chloride resin as electrically insulating materials. These resins involve the following problems, although they are not common to all of these resins.

For example, a group of resins are heated to high temperature of 80°C or higher while in service to thermally expand the heat sink with which they are combined, and shrink while out of service. The electronic part in which this type of resin is combined with a heat sink may be eventually deformed or broken, when it cannot absorb cycles of thermal expansion and shrinkage. Another group of resins are not well filled with a thermoconductive material to harden the thermoconductive sheet prepared, when filled with an excessively large quantity of thermoconductive material for the resin, with the result that the sheet can no longer relax and absorb thermal expansion and shrinkage of the heat sink. When they are filled with an insufficient quantity of a thermoconductive material to avoid the above problems, the resultant sheet has an insufficient thermal conductivity to satisfy the intended object. A still another group of resins have other disadvantages, e.g., high combustibility, insufficient fabricability, generation of toxic substance when incinerated for waste disposal or high cost.

Like these resins, silicone-based resin, rubber and oil have been proposed as the matrix materials for thermoconductive compositions, and a variety of products have been developed. Recently, they have largely replaced the above-described resins to almost monopolize the related markets.

Silicone polymers have a variety of excellent characteristics, e.g., electrical insulation, flame retardancy, resistance to cold weather, heat, oil and water, stress/impact absorption/relaxation, adhesion, tackiness, vibration-proofness, high strength, capacity of being crosslinked by a diversified methods, and possibility of changing fluidity by controlling its molecular weight. Of these various characteristics, only necessary ones can be selected and utilized. This is why these polymers are massively going into the markets.

The representative products of silicone-based resin, rubber, oil or the like combined with a thermoconductive material, e.g., zinc white, silica, alumina, aluminum nitride, boron nitride, silicon nitride, silicon carbide, carbon, diamond or the like include those which use silicone oil, e.g., thermoconductive silicone oil compounds (sometimes referred to as thermoconductive silicone grease compounds); those which use silicone gel, e.g., thermoconductive silicone gel sheets; and those which use crosslinked silicone rubber, e.g., thermoconducvtive silicone rubber compositions (wherein, compound is sometimes referred to as composition, and they are synonymous with each other).

However, a thermoconductive silicone oil compound is a mere mixture of silicone oil of low viscosity and thermoconductive material of low affinity for silicone oil, which causes problems, e.g., separation of silicone oil and trickling of the compound itself which may cause its diffusion or movement to the environments while the compound is in service, to deteriorate its thermal conductivity. Moreover, a silicone oil compound may have a limited thermal conductivity, because silicone oil cannot be incorporated with a thermoconductive material at a sufficiently high content. Nevertheless, however, a thermoconductive silicone oil compound can be easily produced by mixing a thermoconductive material with silicone oil. It can be contained in a tube or syringe (a device, like a medical syringe, which discharges a mobile phase it contains by a piston or vane wheel moving at a constant rate), and discharged easily by a human hand. It is convenient in that it follows a shape coming into contact therewith, even when it is spread on a very small object, surface with irregularities or thin coating film, or it is contained in a very narrow gap. It is adhesive to a contacting object and hence efficiently conducts heat thereto. It is not easily broken by a stress caused by thermal expansion/shrinkage cycles of a contacting heat-generating body and rarely causes failure of the heat-generating body by relaxing stress from a contacting heat sink; and can satisfy its object by only a small quantity. These favorable characteristics secure regular demands and markets for these compounds.

On the other hand, a thermoconductive silicone rubber composition comprising silicone rubber is not directly put or spread in a gap between a heat-generating body and heat sink, unlike a thermoconductive silicone oil compound, but passed through calendar rolls many times and kneaded under heating into a sheet of given thickness, which is crosslinked under heating to have a millable type crosslinked sheet. A large-size crosslinked sheet is cut into a just enough size to fill the gap. It is used as a sheet of small size and specific shape.

However, the crosslinked, thermoconductive sheet is hard to have a Shore hardness of 90 or more, and hence not as well following shape as a thermoconductive silicone oil compound. Therefore, it may break the heat-generating body (electronic part) to which it is pressed to stick fast to enhance heat conducting efficiency. Other ways to crosslink silicone rubber are condensation to produce a room-temperature vulcanizing (RTV) type, and hydrosilylation to produce an addition-crosslinked type. These types of crosslinked, thermoconductive sheets involve the similar problems, although not to an extent to break the heat-generating body.

Nevertheless, however, the thermoconductive silicone rubber composition (sheet) in which silicone rubber is utilized has fairly large markets because of its various favorable characteristics, e.g., heat resistance, high thermal conductivity, high productivity, low cost, high-speed mountability, excellent mechanical properties, stress/impact absorbing/relaxing capacity, and softness-controllability by freely adjusting crosslinking density.

Under these situations, the inventors of the present invention have proposed a thermoconductive silicone rubber composition comprising silicone rubber incorporated with metallic silicone (Japanese Patent Laid-open Publication No.2000-63670), which, however, cannot sufficiently satisfy the requirements by the users. Moreover, the publication, although describing a thermoconductive silicone gel sheet prepared from the composition in EXAMPLE, neither describes nor suggests its relationship with the thermoconductive silicone oil compound and possibility of creating new demand areas by substituting it with others.

US 5,021,494 discloses a thermally conductive silicone composition comprising a polyorganosiloxane, a polyorganohydrogensiloxane, a catalyst selected from the group consisting of platinum and platinum compounds, a heat transfer filler and an adhesion promoter.

JP 11,049,959 discloses a composition having excellent heat dissipation for electric and electronic parts and, at the same time, capable of suppressing physical stress to a minimum obtained by compounding a polyorganosiloxane having at least one alkenyl group, an organopolysiloxane having at least two silicon atom-bonded hydrogen atoms, a platinum catalyst and crushed silica and/or aluminum oxide.

EP 0630 952 discloses a method for bonding substrates with silicone rubber substantially shortens the setting time and provides good bonding of the substrates by using a silicone rubber composition comprised of a thermal-crosslinking component and moisture-crosslinking component.

US 5,518,758 discloses a heat diffuser for conducting heat away from a heat generating assembly, which is composed of a heat-conducting polymeric material formed by dispensing strips of the polymeric material directly onto a surface area of the assembly. A computer-controlled nozzle assembly is utilized to disperse the polymeric material. The heat diffuser may be composed of multiple layers wherein the polymeric material for different layers has different mechanical and/or heat conducting properties.

IBM TECHNICAL DISCLOSURE BULLETIN, IBM CORP. NEW YORK, US, vol. 30, no. 12, 1 May 1988 (1988-05-01), page 146, XP002158633 ISSN: 0018-8689, "Filled Silicone Gel As a Thermal Transfer Medium in Electronic Packages" discloses a silicone gel filled with a thermally conductive powder, such as boron nitride and zinc oxide, which is useful as a thermal transfer medium in semiconductor packages.

### SUMMARY OF THE INVENTION

It is an object of the present invention, in view of the above-described problems, to provide a process for producing a container filled with and sealing an extrudable, crosslinked, grease-like heat-radiating material which solves or reduces disadvantages of the conventional thermoconductive silicone oil/compound while keeping its advantages intact, the disadvantages including phenomenon of its diffusion or oozing out into the environments, limited thermal conductivity of the compound resulting from low loading of a thermoconductive filler in silicone oil (i.e., insufficient content of the filler in the oil), uneven thermal conductivity of the compound resulting from the phase separation of the thermoconductive filler from the silicone oil in a syringe (resulting from the phase separation to cause an uneven distribution of the oil/filler ratio in the compound), and changed properties of the compound resulting from temperature increase of the heat-generating body (e.g., electronic part or motor). Moreover, the applicable areas of the conventional thermoconductive silicone rubber composition or thermoconductive silicone oil compound are limited to formed articles, represented by sheet, and coating. On the other hand, the heat-radiating material contained in a container, e.g., tube or syringe, obtained by the process of the present invention (according to another preferred embodiment, the starting material for silicone gel to be incorporated with a thermoconductive filler may be heated while being held in a container) can be extruded from the container by a weak force, e.g., that produced by clasping the tube or air pushing the piston in the syringe; can be formed under a pressure into any shape after it is extruded from the container; shows no diffusion (oozing-out) phenomenon in a device in which it is used; has shape self-retainability, i.e., retains its shape even when kept under a very light load, e.g., kept on a slanted plate, so long as it is left under the same condition; and undergoes little temporal changes because it is crosslinked.

The inventors of the present invention have found, after having extensively studied to solve the above-described problems, that an extrudable, crosslinked, grease-like heat-radiating material produced by heating a starting material for silicone gel after it is dispersed with a thermoconductive filler, which as a crosslinked product was considered not to flow, unexpectedly flows by a weak force, e.g., that produced by a piston in the syringe in which it is held, can be formed into a specific shape, can retain its shape (shape self-retainability) even when kept under a very light load, e.g., kept on a slanted plate so long as it is left under the same condition, achieving the present invention.

More specifically, the present invention provides a process for producing a container filled with and sealing an extrudable, crosslinked, grease-like heat-radiating material comprising a crosslinked silicone gel (A) dispersed with a thermoconductive filler (B), and shape self-retainable in spite of being fluid, wherein the thermoconductive filler (B) is incorporated at 5 to 500 parts by weight per 100 parts by weight of the crosslinked silicone gel (A) and said crosslinked silicone gel (A) has a consistency of 50 to 100 (determined in accordance with JIS K-2220 with a 1/4 cone) ;
said process comprising the steps of filling with and sealing said container with the mixed solution of the starting material for said crosslinked silicone gel (A) and said thermoconductive filler (B), and heating the whole container body to crosslink the silicone gel it contains.

### DETAILED DESCRIPTION OF THE INVENTION

The present invention is described in more detail.

### 1. Crosslinked silicone gel (A)

The present invention uses a crosslinked silicone gel having a consistency of 50 to 100 (determined in accordance with JIS K-2220 with a 1/4 cone) as the matrix for the extrudable, crosslinked, grease-like heat-radiating material. The crosslinked silicone gel itself is a known chemical material. However, the particularly preferable crosslinked silicone gel is a specific one which simultaneously satisfies various conditions. For example, it is fluid to an extent that it can be extruded from a syringe, tube or the like; kept plastic and shape self-retainable even when incorporated with a thermoconductive filler at a high content; free of a low-molecular-weight silicone compound; and containing a limited quantity of residual alkenyl group and hydrogen group directly bonded to silicon.

The crosslinked silicone gel preferably has a consistency of 50 to 100, determined in accordance with JIS K-2220 with a 1/4 cone. It may be no longer shape self-retainable when its consistency is above 100, to suffer the phenomenon of oozing-out and diffusion into the environments when spread on an object. Consistency of below 50 is also undesirable, because the gel may have deteriorated fluidity.

The process for producing the crosslinked silicone gel for the present invention is not limited. However, it is generally produced by hydrosilylation (addition) reaction between an organo hydrogen polysiloxane and alkenyl polysiloxane as the starting compounds, described later, in the presence of a catalyst.

The starting compounds for the silicone gel for the present invention are in many cases an organo hydrogen polysiloxane and alkenyl polysiloxane.

An organo hydrogen polysiloxane as one of the starting compounds is preferably the one represented by the following general formula (1): 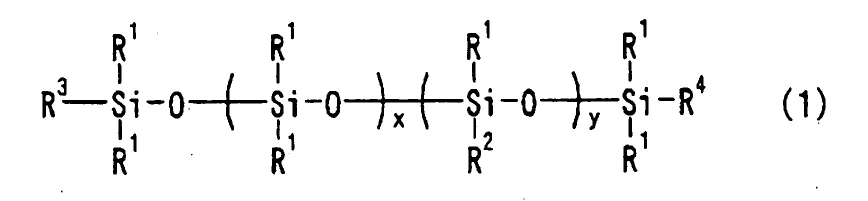 Wherein, R¹s are each a monovalent hydrocarbon group, and may be the same or different, and substituted or not substituted; R², R³ and R⁴ are each R¹ or -H, and at least two of them are -H; "x" and "y" are each an integer representing number of each unit, which may be arranged in a block or randomly, the latter being more preferable; "x" is an integer of 0 or more, preferably 10 to 30; "y" is an integer of 0 or more, preferably 1 to 10; and "x+y" is an integer of 5 to 300, preferably 30 to 200.

At the same time, y/(x+y) is preferably 0.1 or less, beyond which number of the crosslinking sites may be excessive and the extrudable, crosslinked, grease-like heat-radiating material may not be obtained.

The examples of R¹ include alkyl groups, e.g., methyl, ethyl, propyl and butyl; cycloalkyl groups, e.g., cyclopentyl and cyclohexyl; aryl groups, e.g., phenyl and tolyl; aralkyl, e.g., benzyl and phenylethyl; and halogenated hydrocarbons with the hydrogen atom in the above groups being partly substituted by chlorine, fluorine, or the like.

Hydrogen directly bonded to the silicon atom (Si-H) is essential for the addition (hydrosilylation) reaction with the alkenyl group directly or indirectly bonded to the silicon atom, and the organo hydrogen polysiloxane molecule must have at least two Si-H hydrogen atoms. A smaller number of the hydrogen atoms directly bonded to the silicon atom is undesirable, because number of the crosslinking sites is insufficient to form the silicone gel for the present invention, the resultant gel being characteristically similar to the silicone oil. An excessively large number of the hydrogen atoms directly bonded to the silicon atom is also undesirable, because number of the crosslinking sites is excessive to make the resultant gel characteristically similar to the silicone rubber.

It is needless to say that there is an adequate ratio of number of the Si-H group in the organo hydrogen polysiloxane to that of the alkenyl group in the alkenyl polysiloxane. The Si-H group/alkenyl group ratio is preferably 0.85 to 1.25, particularly preferably 0.9 to 1.1, for the present invention. The ratio within the above range will bring favorable effects, e.g., decreased quantity of the residual alkenyl group in the gel to reduce oxidation-caused ageing of the heat-radiating material in an electronic device in which it works, and decreased quantity of the residual Si-H group to reduce deterioration of thermal conductivity caused by generation of hydrogen.

The alkenyl polysiloxane as the other starting compound for producing the crosslinked silicone gel for the present invention is preferably the one represented by the following general formula (2): 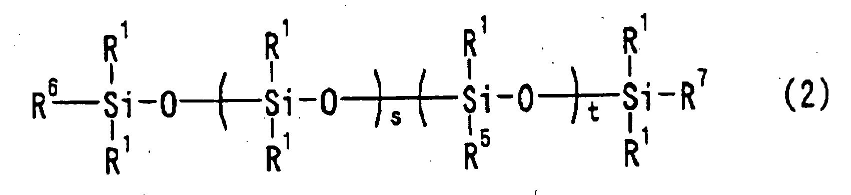 Wherein, R¹s are each a monovalent hydrocarbon group, and may be the same or different, and substituted or not substituted; R⁵, R⁶ and R⁷ are each R¹ or alkenyl group, and at least two of them are alkenyl group; "s" and "t" are each an integer representing number of each unit, which may be arranged in a block or randomly, the latter being more preferable; "s" is an integer of 0 or more,; "t" is an integer of 0 or more; and "s+t" is an integer of 10 to 600. At the same time, t/(s+t) is preferably 0.1 or less, beyond which number of the crosslinking sites may be excessive and the extrudable, crosslinked, grease-like heat-radiating material may not be obtained.

The examples of R¹ include alkyl groups, e.g., methyl, ethyl, propyl and butyl; cycloalkyl groups, e.g., cyclopentyl and cyclohexyl; aryl groups, e.g., phenyl and tolyl; aralkyl, e.g., benzyl and phenylethyl; and halogenated hydrocarbons with the hydrogen atom in the above groups being partly substituted by chlorine, fluorine, or the like.

The alkenyl group (e.g., vinyl or allyl) directly or indirectly bonded to the silicon atom is essential for the addition (hydrosilylation) reaction with the hydrogen atom directly bonded to the silicon atom (Si-H), and the alkenyl polysiloxane molecule must have at least two alkenyl groups. A smaller number of the alkenyl group is undesirable, because number of the crosslinking sites is insufficient to form the silicone gel for the present invention, the resultant gel being characteristically similar to the silicone oil. An excessively large number of the hydrogen atoms is also undesirable, because number of the crosslinking sites is excessive to make the resultant gel characteristically similar to the silicone rubber.

It is needless to say that there is an adequate ratio of number of the alkenyl groups in the alkenyl polysiloxane to that of the hydrogen atom directly bonded to the silicon atom (Si-H) in the organo hydrogen polysiloxane. The Si-H group/alkenyl group ratio is preferably 0.85 to 1.25, particularly preferably 0.9 to 1.1, for the reason described earlier.

The number "s+t" determines distance between the crosslinking sites. An excessively small number is undesirable, because it means an excessively large number of the crosslinking sites. An excessively large number is also undesirable, because it means an excessively small number of the crosslinking sites, and excessively large molecular weight of the gel, making it difficult to smoothly discharge the resultant heat-radiating material from a syringe.

The hydrogen polysiloxane for the present invention, represented by the general formula (1), has the -H (hydrogen group) directly bonded to the silicon atom, and the alkenyl polysiloxane represented by the general formula (2) has the C-C double bond. Therefore, the C-C double bond and -H (hydrogen group) react with each other through the addition reaction, which is referred to as hydrosilylation.

The hydrosilylation reaction can be effected by a known process, in the presence or absence of organic solvent. The solvents useful for the reaction include alcohols, e.g., ethanol and isopropyl alcohol; aromatic hydrocarbons, e.g., toluene and xylene; ethers, e.g., dioxane and THF; and other organic solvents, e.g., aliphatic and chlorinated hydrocarbons. Reaction temperature is normally 50 to 150°C. A catalyst can be used for the reaction, and the useful catalysts include chloroplatinic acid, a complex of chloroplatinic acid and alcohol, platinum/olefin complex, platinum/vinyl siloxane complex and platinum/phosphorus complex.

The catalyst is used normally at 1 to 500ppm as platinum atom, based on the alkenyl polysiloxane, preferably 3 to 250ppm in consideration of curability of the gel and physical characteristics of the cured product.

### 2. Thermoconductive filler (B)

The thermoconductive filler for the present invention is not limited, so long as it works to conduct heat generated by the heat-generating body to the heat-radiating body. The representative ones include oxides, e.g., ferrite, aluminum oxide, silicon oxide, boron oxide, titanium oxide, zirconium oxide, zinc white and zinc oxide; nitrides, e.g., aluminum, silicon, boron, titanium and zirconium nitride; and carbon nanotube, carbon microcoil, pure iron, diatomaceous earth, calcium carbonate, talc, clay, bentonite and mica. Of these, more preferable ones include ferrite, aluminum nitride, boron nitride, silicon nitride, aluminum oxide and silicon oxide. Even carbon and metal powder (copper, aluminum, or the like) may be used, when electrical insulation of the heat-radiating material is not very important. These thermoconductive fillers may be used either individually or in combination, as required.

The thermoconductive filler has an average particle size of 0.1 to 100µm, preferably 0.5 to 50µm. The filler having an average particle size below 0.1µm is difficult to produce, and also difficult to uniformly disperse in the matrix, because particles agglomerate each other. The filler having an average particle size above 100µm is also undesirable, because it deteriorates thermal conductance efficiency per unit amount.

It is preferable to combine the particles having an average size of 5 to 50µm with the smaller ones having an average size of 0.1 to 5µm in a ratio at which they follow the distribution curve of closest packing theory, because it can improve packing efficiency, thereby decreasing viscosity and increasing thermal conductivity of the heat-radiating material.

The thermoconductive filler is preferably surface-treated with a silane coupling agent to improve its affinity for the silicone gel, fluidity and dispersibility. The silane coupling agents useful for the present invention include γ-chloropropyltrimethoxysilane, vinyl trichlorosilane, vinyl triethoxysilane, vinyl trimethoxysilane, vinyl tris(β-methoxyethoxy)silane, γ-methacryloxypropyltrimethoxysilane, β·(3,4-epoxycyclohexyl)ethyltrimethoxysilane, γ-glycidoxypropyltrimethoxysilane, γ·mercaptopropyltrimethoxysilane, γ·aminopropyltriethoxysilane, N-β-(aminoethyl)-γ-aminopropyltriethoxysilane and γ-ureidoaminopropyltriethoxysilane. The silane coupling agent is incorporated at 0.1 to 10 parts by weight per 100 parts by weight of the thermoconductive filler, preferably 0.5 to 5 parts by weight.

The thermoconductive filler (B) is incorporated at 5 to 500 parts by weight per 100 parts by weight of the crosslinkable silicone gel (A). Incorporation of the thermoconductive filler (B) at beyond the above range is undesirable. The extrudable, crosslinked, grease-like heat-radiating material may have an insufficient thermal conductivity at below 5 parts by weight, and may be difficult to extrude from a syringe or the like, because of deteriorated fluidity, at above 500 parts by weight.

### 3. Extrudable, Crosslinked, Grease-like Heat-Radiating Material

The extrudable, crosslinked, grease-like heat-radiating material for the present invention comprises the crosslinked silicone gel dispersed with the thermoconductive filler. The term "crosslinked" is used to indicate that the crosslinked silicone gel is used as the matrix. The term "extrudable" is used because the extrudable, crosslinked, grease-like heat-radiating material for the present invention can be extruded from a container, e.g., syringe, filled with and sealing the material to fill a gap of any shape between the heat-generating body (e.g., electronic part or motor) and heat-radiating body (e.g., heat sink) by being poured or pushed thereinto.

"The extrudable, crosslinked, grease-like heat-radiating material is put or placed in a gap between a heat-generating body and heat-radiating body" means that it is pushed into any gap to fill it, and also that it is poured onto or coated on an open area having no closed space, and then covered with another material to first fill the space it forms.

The above terms are viewed from different angles. The extrudable, crosslinked, grease-like heat-radiating material for the present invention is crosslinked unlike known thermoconductive silicone oil compounds. It is of different type from known thermoconductive silicone oil compounds, and developed based on a different technical concept. This is the reason for describing it as a "crosslinked" material. Moreover, known thermoconductive silicone rubber are not used to fill a gap of any shape after being contained in a syringe and extruded therefrom, unlike the one used in the present invention. The term "extrudable" is used to indicate that the process of the present invention is technically different from known thermoconductive silicone rubber.

The term "shape self-retainability" is used to indicate that the extrudable, crosslinked, grease-like heat-radiating material used in the process of the present invention shows characteristics different from those of known thermoconductive silicone oil compounds in that it can retain its shape after filling a gap, even when kept under a very light load, e.g., kept on a slanted plate.

### 4. Container

A "syringe sealing thermoconductive silicone oil compound" is known and being used. It involves various problems, e.g., trickling and oozing-out of the liquid, low thermal conductivity, insulated electrical contact points and difficulty in filling a gap of any shape. The container obtained by the process of the present invention is to improve the conventional container. A "container filled with and sealing the extrudable, crosslinked, grease-like heat-radiating material" has not been put in the markets.

The container obtained by the process of the present invention is sold as "the container filled with and sealing the extrudable, crosslinked, grease-like heat-radiating material," and is represented by syringe, tube or the like.

Therefore, the "container" obtained by the process of the present invention is provided with various functions, e.g., fluid-containing section, fluid-charging and-discharging port, piston or vane wheel for charging or discharging fluid, cap and seal, among others, to hold a fluid and charging and/or discharging a given quantity of the fluid.

The container can work when provided with those selected from piston or vane wheel for fluid-charging and-discharging port, cap, seal, and so forth. Taking a syringe as an example, there are various types, e.g., one having both fluid-charging and-discharging port, another one having one port for fluid charging and discharging, still another one originally having both fluid-charging and-discharging port, the former being sealed after the fluid is charged to leave the latter, still another one originally having both fluid-charging and-discharging port, both being sealed after the fluid is charged, and still another one provided with a means for sealing the fluid-charging and/or -discharging port, e.g., one selected from plug, threaded cap, and seal to be put under heating or pressure.

The container may be provided with various other means, e.g., heating, cooling, pressure reducing, pressurizing, inducing, evaporating, motoring, hydraulic, pneumatic, measuring, dust-proofing, handling facilitating (auxiliary means), displaying, generated gas releasing, reverse flow preventing and temperature sensing means. Most widely used container types are syringe and tube.

Two methods can be cited for putting and sealing the extrudable, crosslinked, grease-like heat-radiating material in the container. Of these, the following two methods can be cited as the representative ones.
(1) The container is filled with and sealing the crosslinked, grease-like heat-radiating material comprising the crosslinked silicone gel (A) dispersed with the thermoconductive filler (B), produced by heating the starting material for the crosslinked silicone gel (A) while or after it is mixed with the thermoconductive filler (B).
   According to this method, large quantities of the starting material for the crosslinked silicone gel (A) can be mixed and heated with the thermoconductive filler (B) in a large vessel. Therefore, it can give the product at increased productivity. It is necessary to defoam the heat-radiating material while it is put and sealed in the container, to prevent foams from being caught by the material.
(2) The container is filled with and sealing the mixed solution of the starting material for the crosslinked silicone gel (A) and thermoconductive filler (B) to disperse the thermoconductive filler (B) in the crosslinked silicone gel (A), and the whole container body is heated to crosslink the silicone gel it contains.

According to this method, a mixture of the starting material for the crosslinked silicone gel (A) and thermoconductive filler (B) is a low-viscosity liquid, and hence can be put and sealed in a container, e.g., syringe or tube, while preventing foams from being caught by the mixture. As a result, it can be used in a higher-quality state.

### 5. Method of radiating heat from a device

The extrudable, crosslinked, grease-like heat-radiating material is extruded from the discharge port of the container in which it is put and sealed, and then put or placed in a gap between a heat-generating body and heat-radiating body in a device, e.g., electronic device or motor, to release unnecessary heat generated in the device via the crosslinked, grease-like heat-radiating material.

The heat-generating devices include electronic devices, e.g., personal computer, microprocessor and CD-ROM drive, and other devices, e.g., motor, power source, transformer and battery.

### EXAMPLES and COMPARATIVE EXAMPLES

The present invention is described in more detail by EXAMPLES and COMPARATIVE EXAMPLES, which by no means limit the present invention.

### EXAMPLE 1

100 parts by weight of an addition-reaction type silicone gel curable to a consistency of 65 (determined in accordance with JIS K-2220 with a 1/4 cone) (Toray/Dow Corning Silicone's CF5106), 20 parts by weight of aluminum nitride powder (average particle size: 3.5µm, specific surface area: 2.9m²/g) surface-treated with vinyl trimethoxysilane and 30 parts by weight of boron nitride powder (average particle size: 5.4µm, specific surface area: 4.2m²/g) were uniformly dispersed in a reactor under a vacuum defoaming condition. The resultant mixture was charged in a syringe (net volume: 30cm³) through a charging/discharging port (cross-sectional area: 2mm²) under a vacuum defoaming condition. The whole syringe body, containing the mixture, was heated at 80°C for 30 minutes, to produce the "syringe filled with and sealing the extrudable, crosslinked, grease-like heat-radiating material" by crosslinking the silicone gel. The extrudable, crosslinked, grease-like heat-radiating material could be discharged from the port, when the piston in the syringe was lightly pushed by a thumb. It was tested by the following procedure to evaluate its characteristics.

### [Procedure for testing diffusion (oozing-out) phenomenon]

50g of the extrudable, crosslinked, grease-like heat-radiating material prepared in EXAMPLE 1 was put between two glass sheets, which were pressed to a gap of 2mm, i.e., to press the material to a thickness of 2mm. It was left in a horizontal and slanted condition after pressure was released. It was then continuously subjected to cycles of -4°C for 30 minutes and 100°C for 30 minutes in an environment tester, to confirm the material conditions.

### [Evaluation results]

The sample placed in a horizontal condition showed no diffusion (oozing-out) phenomenon, with its peripheries retaining the original shape. The one placed in a slanted condition showed no liquid-trickling condition.

The extrudable, crosslinked, grease-like heat-radiating material underwent little temporal changes, because it was crosslinked.

The extrudable, crosslinked, grease-like heat-radiating material had an excellent thermoconductivity of 1.5W/m·K, determined by a Kyoto Electronics Manufacturing's quick thermoconductivity meter QTM-500.

### EXAMPLE 2

100 parts by weight of an addition-reaction type silicone gel curable to a consistency of 65 (determined in accordance with JIS K-2220 with a 1/4 cone) (Toray/Dow Corning Silicone's CF5106), 20 parts by weight of aluminum nitride powder (average particle size: 3.5µm, specific surface area: 2.9m²/g) surface-treated with vinyl trimethoxysilane and 30 parts by weight of boron nitride powder (average particle size: 5.4µm, specific surface area: 4.2m²/g) were uniformly dispersed in a reactor under a vacuum defoaming condition. The resultant mixture was heated at 80°C for 30 minutes, and charged in a syringe (net volume: 30cm³) through a charging/discharging port (cross-sectional area: 2mm²) under a vacuum defoaming condition, to obtain the "syringe filled with and sealing the extrudable, crosslinked, grease-like heat-radiating material". The extrudable, crosslinked, grease-like heat-radiating material could be discharged from the port, when the piston in the syringe was lightly pushed by a thumb. It was tested by the following procedure to evaluate its characteristics.

### [Procedure for testing diffusion (oozing-out) phenomenon]

50g of the extrudable, crosslinked, grease-like heat-radiating material prepared in EXAMPLE 2 was put between two glass sheets, which were pressed to a gap of 2mm, i.e., to press the material to a thickness of 2mm. It was left in a horizontal and slanted condition after pressure was released. It was then continuously subjected to cycles of -4°C for 30 minutes and 100°C for 30 minutes in an environment tester, to confirm the material conditions.

### [Evaluation results]

The sample placed in a horizontal condition showed no diffusion (oozing-out) phenomenon, with its peripheries retaining the original shape. The one placed in a slanted condition showed no liquid-trickling phenomenon.

The extrudable, crosslinked, grease-like heat-radiating material underwent little temporal changes, because it was crosslinked.

The extrudable, crosslinked, grease-like heat-radiating material had an excellent thermoconductivity of 1.5W/m·K, determined by a Kyoto Electronics Manufacturing's quick thermoconductivity meter QTM-500.

### COMPARATIVE EXAMPLE 1

A commercial fluid, thermoconductive silicone oil compound, which was not crosslinked, was tested in the same manner as in EXAMPLE 1 for the diffusion (oozing-out) phenomenon to evaluate its characteristics.

### [Evaluation results]

The compound placed in a horizontal condition showed a diffusion (oozing-out) phenomenon, with its peripheries not retaining the original shape. The one placed in a slanted condition showed a trickling phenomenon.

The compound, which was not crosslinked, underwent temporal changes.

### COMPARATIVE EXAMPLE 2

100 parts by weight of an addition-reaction type silicone gel (Toray/Dow Corning Silicone's CF5106) curable to a penetration of 40 at a load of 50g (JIS K-2207-1980), 20 parts by weight of aluminum nitride powder (average particle size: 3.5µm, specific surface area: 2.9m²/g) surface-treated with vinyl trimethoxysilane and 30 parts by weight of boron nitride powder (average particle size: 5.4µm, specific surface area: 4.2m²/g) were uniformly dispersed in a reactor under a vacuum defoaming condition. The resultant mixture was charged in a syringe (net volume: 30cm³) through a charging/discharging port (cross-sectional area: 2mm²) under a vacuum defoaming condition. The whole syringe body, containing the mixture, was heated at 80°C for 30 minutes, to produce the "syringe filled with and sealing the heat-radiating material." However, this could not produce the "syringe filled with and sealing the extrudable, crosslinked, grease-like heat-radiating material", because the material could not be discharged through the port even when the piston was pushed strongly by a pneumatic force or the like.

The extrudable, crosslinked, grease-like heat-radiating material used in the present invention, capable of uniformly dispersing a thermoconductive filler in a silicone gel, has an increased thermal conductivity uniformly distributed in the whole body, because the thermoconductive filler shows no separation or segregation even present at a high content.

It can be put in a container, e.g., tube or syringe, like grease, paste, clay or the like (according to another preferred embodiment, the container containing the starting material for silicone gel to be incorporated with a thermoconductive filler may be heated) and extruded from the container by a weak force, e.g., that produced by clasping the tube or air pushing the piston in the syringe. It can be formed under a pressure into any shape after it is extruded from the container; shows no diffusion (oozing-out) phenomenon in a device in which it is used; has shape self-retainability, i.e., retains its shape even when kept under a very light load, e.g., kept on a slanted plate, so long as it is left under the same condition; and undergoes little temporal changes because it is crosslinked. Moreover, the applicable areas of the conventional thermoconductive silicone rubber composition or thermoconductive silicone oil compound are limited to formed articles, represented by sheet, and coating. On the other hand, the heat-radiating material used in the present invention can find completely new ways of use (in terms of methods of operation and putting it in a service area), because it can be formed into any shape after it is extruded from the container in which it is held (e.g., syringe or tube) to be put or placed in a gap of any shape between a heat-generating body and heat-radiating body, where it keeps shape self-retainability, i.e., retains its shape even when kept under a very light load, e.g., kept on a slanted plate. The present invention contributes to extended service life, improved function, decreased failure, simplified maintenance works and decreased cost, among others, of the device.

## Claims

1. A process for producing a container filled with and sealing an extrudable, crosslinked, grease-like heat-radiating material comprising a crosslinked silicone gel (A) dispersed with a thermoconductive filler (B), and shape self-retainable in spite of being fluid, wherein the thermoconductive filler (B) is incorporated at 5 to 500 parts by weight per 100 parts by weight of the crosslinked silicone gel (A) and said crosslinked silicone gel (A) has a consistency of 50 to 100 determined in accordance with JIS K-2220 with a 1/4 cone;
said process comprising the steps of filling with and sealing said container with the mixed solution of the starting material for said crosslinked silicone gel (A) and said thermoconductive filler (B), and heating the whole container body to crosslink the silicone gel it contains.

2. The process according to Claim 1, wherein said thermoconductive filler (B) is at least one compound selected from the group consisting of ferrite, aluminum nitride, boron nitride, silicon nitride, aluminum oxide and silicon oxide

3. The process according to Claim 1 or 2 wherein said container has a shape of syringe or tube.

4. The process according to any one of Claims 1 to 3, wherein the crosslinked, grease-like heat-radiating material put and sealed in said container is put or placed in a gap between a heat-generating body and heat-radiating body in a device, e.g., electronic device or motor, to release unnecessary heat generated in said device via said crosslinked, grease-like heat-radiating material.

## Patentansprüche

1. Verfahren zur Herstellung eines Behälters, der gefüllt wird und Versiegelung eines extrudierbaren, vernetzten, fettähnlichen wärmeabstrahlenden Materials, welches ein vernetztes Silikongel (A) umfasst, das mit einem wärmeleitenden Füllmaterial (B) dispergiert wird, und trotz flüssigen Zustandes eine selbsterhaltende Form aufweist, wobei das wärmeleitende Füllmaterial (B) 5 bis 500 Gewichtsteile pro 100 Gewichtsteile des vernetzten Silikongels (A) enthält und das vernetzte Silikongel (A) eine Konsistenz von 50 bis 100 hat, was in Übereinstimmung mit JIS K-2220 mit einem 1/4 Konus bestimmt wird;
wobei das Verfahren die Schritte Befüllen und Versiegeln des Behälters mit der gemischten Lösung des Ausgangsmaterials für das vernetzte Silikongel (A) und das wärmeleitende Füllmaterial (B), und das Erwärmen des ganzen Behältergehäuses zur Vernetzung des enthaltenen Silikongels, umfasst.

2. Verfahren nach Anspruch 1, wobei das wärmeleitende Füllmaterial (B) mindestens eine Verbindung aufweist, die ausgewählt wird aus der Gruppe bestehend aus Eisenoxid, Aluminiumnitrid, Bornitrid, Siliziumnitrid, Aluminiumoxid und Siliziumoxid.

3. Verfahren nach Anspruch 1 oder 2, wobei der Behälter die Form einer Spritze oder eines Röhrchens hat.

4. Verfahren nach einem der Ansprüche 1 bis 3, wobei das vernetzte, fettähnliche wärmeabstrahlende Material, welches in den Behälter eingebracht und versiegelt wird, in eine Lücke zwischen einen wärmeerzeugenden Körper und einen wärmeabstrahlenden Körper in ein Gerät, z.B. ein elektronisches Gerät oder Motor, eingebracht oder platziert wird, um nicht benötigte Wärme, die in diesem Gerät erzeugt wird, über das vernetzte, fettähnliche wärmeabstrahlende Material abzugeben.

## Revendications

1. Procédé de production d'un conteneur rempli de et scellé avec un matériau irradiant la chaleur du type graisse, extrudable et réticulé, et comprenant un gel de silicone réticulé (A) dispersé à l'aide d'une charge thermoconductrice (B), et gardant sa forme bien que fluide, dans laquelle la charge thermoconductrice (B) est introduite à raison de 5 à 500 parties en poids pour 100 parties en poids de gel de silicone réticulé (A), et le gel de silicone réticulé (A) a une consistance de 50 à 100 telle que déterminée selon JIS K-2220 avec un cône ¼, le procédé comprenant les étapes consistant à remplir et à sceller le conteneur avec le mélange de la solution du matériau de départ du gel de silicone réticulé (A) et de la charge thermoconductrice (B), et à chauffer tout le corps du conteneur pour réticuler le gel de silicone qu'il contient.

2. Procédé selon la revendication 1, dans lequel la charge thermoconductrice (B) est au moins un composé choisi dans le groupe consistant en la ferrite, le nitrure d' aluminium, le nitrure de bore, le nitrure de silicium, l'oxyde d'aluminium et l'oxyde de silicium.

3. Procédé selon la revendication 1 ou 2, dans lequel le conteneur a la forme d'une seringue ou d'un tube.

4. Procédé selon l'une quelconque des revendications 1 à 3, dans lequel le matériau extrudable irradiant la chaleur de type graisse placé et scellé dans le conteneur est placé et scellé dans un espace compris entre le corps générant la chaleur et le corps irradiant la chaleur dans un dispositif, par exemple un dispositif électronique ou un moteur, afin d'éliminer la chaleur superflue générée dans le dispositif au moyen du matériau réticulé irradiant la chaleur du type graisse.
